# EUROPEAN PATENT APPLICATION

(11) **EP 0 532 355 A2**
(43) Date of publication of application: **17.03.1993**
(21) Application number: 92308310.9
(22) Date of filing: 11.09.1992
(51) Int. Cl.: H01L 21/331, H01L 29/73, H01L 29/10

(54) **Method for manufacturing a bipolar transistor having a reduced collector-base capacitance**

(30) Priority: 12.09.1991 JP 232719/91
(71) Applicant: NEC CORPORATION, Tokyo (JP)
(72) Inventor: Kano, Isao, Minato-ku, Tokyo (JP)
(74) Representative: Moir, Michael Christopher

(57) **Abstract**

A method for manufacturing a bipolar transistor which includes a step of preparing a semiconductor substrate of first conductivity type (10), a step of sequentially forming a thin first insulating film (30), an electrically conducting film containing a second conductivity type impurity (15,31), and a second insulating film (32) on the semiconductor substrate (10), a step of forming an opening (40) by anisotropically etching the second insulating film (32) and the conductive film (15,31) in selective manner, a step of exposing the semiconductor surface by etching the first insulating film (30), a step of depositing a base layer (18) of the second conductivity type on the surface of the semiconcuctor substrate (10) exposed in the opening by epitaxial deposition.

## Description

### BACKGROUND OF THE INVENTION

### Field of the Invention

The present invention relates to a method for manufacturing a bipolar transistor, and more particularly to a method for manufacturing a self-aligned bipolar transistor.

### Description of the Prior Art

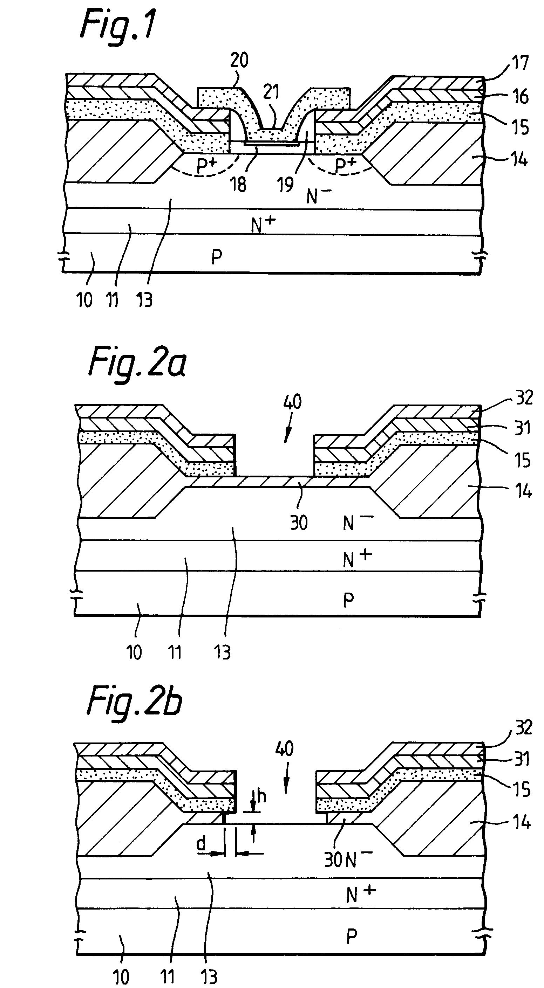

A transistor in which a graft base is formed in self-alignment manner using polysilicon as a diffusion source in order to realize a high-speed transistor by reducing the base resistance and the junction capacitance has been disclosed in IEEE Electron Device Letters, Vol. 9, No. 5, May 1988, pp. 259-261. Referring to FIG. 1, this selective epitaxial base transistor will be described. After forming an N⁺ -type buried layer 11 a P-type silicon substrate 10, an N-type epitaxial layer 13 is grown. Next, after formation of a field oxide film 14 by selective oxidation, a polysilicon film 15 for leading out the base electrode is deposited by a CVD method, and boron ions are implanted to a high concentration. Next, a silicon oxide film 16 and a silicon nitride film 17 are deposited sequentially by the CVD method. Next, an opening is formed by reactive ion etching.

Next, a thin oxide film is formed by thermal oxidation, and the layer damaged by the reactive ion etching is eliminated by removing the oxide film. Next, a selective epitaxial base 18 is formed at 900°C by using SiCℓ4. The deposition rate of the base 18 is 25 nm/min. Next, after deposition of an insulating film allover the surface, a sidewall spacer 19 is formed on the side surface of the opening by etching back the insulating film. Next, a second polysilicon film 20 is deposited, and an emitter 21 is formed by subjecting the device to a heat treatment following high concentration ion implantation of arsenic. This conventional selective epitaxial base transistor has the following three drawbacks. Namely:
1. Boron will diffuse to the surface of the epitaxial layer from the high concentration P-type polysilicon film deposited on the N-type epitaxial layer by the heat treatment that follows the deposition of the polysilicon film. This brings about an increase of the collector-base capacitance. In particular, when the present method is applied to a Bi-CMOS integrated circuit, the increase in the collector-base capacitance amounts to a very large quantity since there are required several to ten odd times of heat treatment for the formation of the CMOS part.
2. In forming the opening by the reactive ion etching, it is difficult to complete the etching of the P-type polysilicon film for leading out the base electrode without etching the N-type epitaxial layer. This is due to the small value of the selectivity ratio of polysilicon to silicon. Moreover, the surface damage caused by the reactive ion etching can be reduced considerably by the formation and subsequent removal of the thin thermal oxide film, but the damage can never be eliminated completely. Because of this, a feeble leakage current is generated in the base current, which deteriorates the linearity of the current amplification factor. This gives rise to a big problem especially in a linear integrated circuit in which the processing of weak currents is required.
3. Due to misalignment of the field oxide film and the opening formed by the reactive ion etching, there is generated an unbalance of the planar dimensions of the graft base between both sides of the emitter. The unbalance will not be much of a problem in a double base transistor in which the base electrode is taken out from both sides of the emitter, because of the averaging-out of the effect. However, it could lead to a problem in a single base transistor in which the base electrode is taken out from only one side of the emitter due to the irregularity that appears in the base resistance. Increase of the distance between the field oxide film and the opening formed by the reactive ion etching can be considered as a possible countermeasure to this effect, but it is not desirable because of the resultant increase in the parasitic capacitance.

### SUMMARY OF THE INVENTION

It is a major object of this invention to resolve the above-mentioned problems existing in the prior art and to provide a stabilized method for manufacturing which enables one to obtain a bipolar transistor having reduced collector-base capacitance as well as base resistance that is operable at high speed.

In accordance with this invention there is obtained a method for manufacturing a bipolar transistor which includes a step of preparing a semiconductor substrate of first conductivity type, a step of sequentially forming a thin first insulating film, an electrically conducting film containing a second conductivity type impurity and a second insulating film on the semiconductor substrate, a step of forming an opening by anisotropically etching the second insulating film and the conductive film in selective manner, a step of exposing the semiconductor substrate by etching the first insulating film by using the second insulating film and the conductive film with the opening formed therein as the mask, a step of depositing a base layer of the second conductivity type on the surface of the semiconductor substrate exposed in the opening, a step of forming a sidewall spacer on the side surface of the opening by deposition and subsequent etching of a third insulating film, and a step of forming an emitter by subjecting the device to heat treatment after formation of a conductive film containing a second conductivity type impurity.

The invention also provides a bipolar transistor comprising a semiconductor substrate of a first conductivity type; a thin first insulating film, an electrically conductive film containing a second conductivity type impurity and a second insulating film on the semiconductor substrate; an opening in said second insulating film, said conductive film, and said first insulating film; the opening being wider in the first insulating layer than in the second insulating film and the conductive film; a base layer of second conductivity type covering the semiconductor substrate within said opening; an insulating sidewall spacer on the side face of said opening; and an emitter of a heat-treated conductive film containing a second conductivity type impurity.

The above and further objects, features and advantages of the present invention will become more apparent from the following detailed description of the embodiments taken in conjuction with the accompanying drawings, wherein:
Figure 1 is a sectional view showing the conventional bipolar transistor;
Figure 2a to Figure 2d are sectional views showing an embodiment of the invention; and
Figure 3a and Figure 3b are sectional views showing another embodiment of the invention.

Next, referring to the drawings, the present invention will be described.

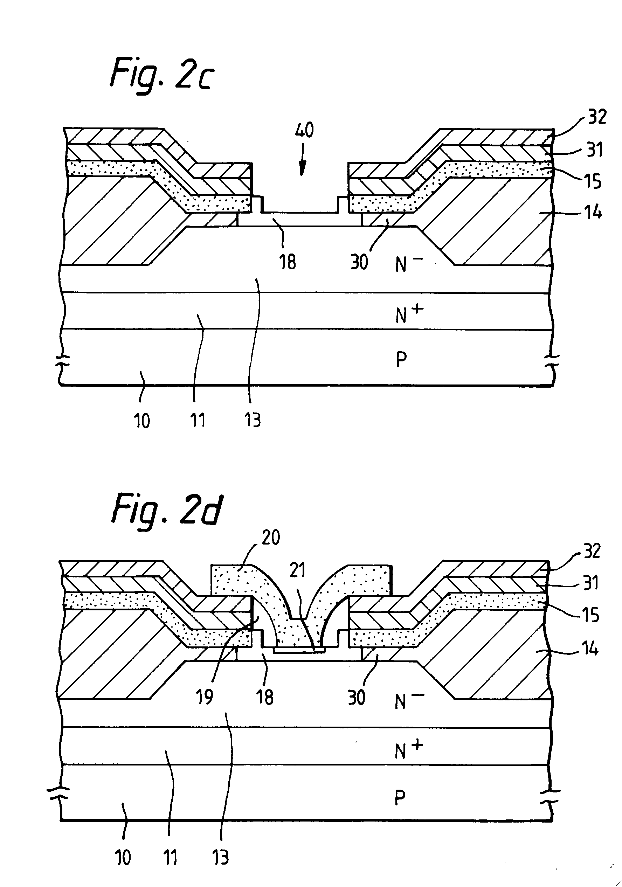

Referring to Figures 2a to 2d which describe the first embodiment of this invention, first an N⁺-type buried layer 11 is formed selectively in a P-type silicon substrate 10, followed by the deposition of an N-type epitaxial film 13 which will be served as the collector to a thickness of 0.5 to 1.0 µm, as shown in FIG. 2a. Next, a field oxide film 14 for element isolation is formed by a selective oxidation method. Next, a thin first insulating film 30 with thickness of 20 to 60 nm is formed allover the surface by thermal oxidation. Next, P-type polysilicon 15 and a conductive film consisting of a metal silicide 31 of a refractory metal are formed. The dose for boron ion implantation to the P-type polysilicon 15 which becomes the source of diffusion for a graft base is desirable to lie in the range of 1 x 10¹³ to 5 x 10¹⁴ cm⁻². Next, N-type polysilicon which will become a collector electrode and a conductive film consisting of a metal silicide of refractory metal are formed (the collector part is not shown). Next, a second insulating film 32 consisting of a silicon nitride film of thickness 100 to 200 nm is formed. Next, the second insulating film 32, the metal silicide 31 and the P-type polysilicon 15 are selectively etched by anisotropic etching to form an opening 40. Next, as shown in FIG. 2b, the first insulating film 30 beneath the P-type polysilicon 15 is side-etched by isotropic wet etching. The width d of the base electrode lead-out part is determined by this side etching. If the ratio d/h of the width/height of this overhang is not less than 3, embedding by selective epitaxial growth becomes difficult. Further, the rate of the selective epitaxial burying is larger in the vicinity of the entrance to the cavity formed by the overhang so that d = 100 nm or thereabout is desirable for h = 50 nm. Next, as shown in FIG. 2c, a selective epitaxial base 18 with boron concentration of 1 x 10¹⁸ to1 x 10¹⁹ cm⁻³ is formed on the bottom surface of the opening 40, the overhang part and the side face of the polysilicon 15 by carrying out selective epitaxial deposition at a lowered pressure and at 900°C by using SiCℓ₄ as the source gas. Next, as shown in FIG. 2d, a third insulating film is deposited all over the surface and it is etched back to leave a sidewall spacer 19. Next, a second polysilicon film 20 with thickness of 100 to 300 nm is deposited. Next, emitter 21 is formed on the surface of the selective epitaxial base 18 by ion implantation or thermal diffusion of an N-type impurity through the second polysilicon 20, completing the element part.

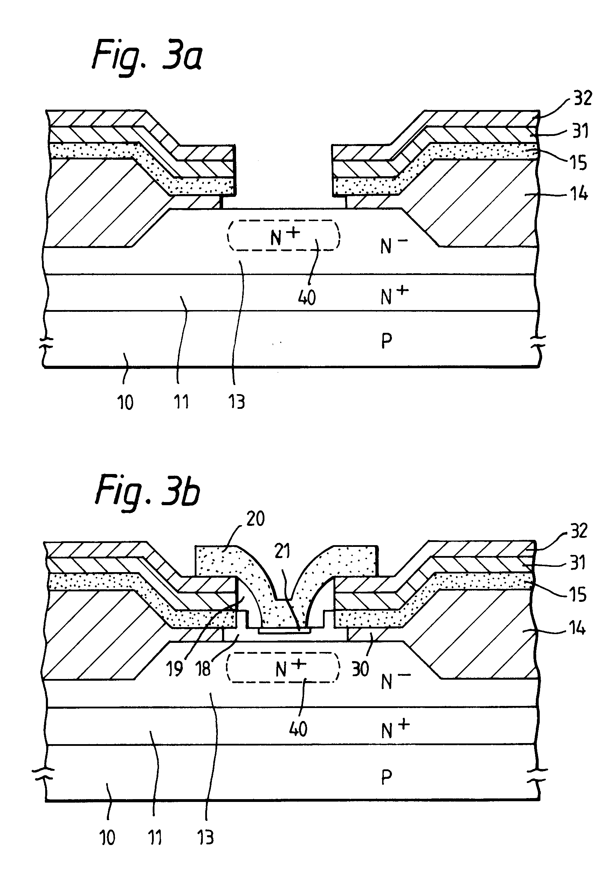

Next, the second embodiment of this invention will be described by reference to FIGS. 3a and 3b. Up to the stages corresponding to those of FIGS. 2a and 2b it is the same as in the first embodiment. Following that, a second buried collector 40 is formed by ion implantation of an N-type impurity, as shown in FIG. 3a. Next, as shown in FIG. 3b, the element part is completed by forming the selective epitaxial base 18, the sidewall spacer 19, the second polysilicon 20 and the emitter 21 in the same manner as in the first embodiment. Implementation of the second buried collector 40 is effective for reducing the enlargement of effective base width at higher current region, named as Kerk effect. Controllability of the distance between the bottom of the base and the second buried collector 40 is better than that of prior ion implanted base process. According to this embodiment, it is further possible to obtain a bipolar transistor having a high value of f_{T} (cut-off frequency).

In accordance with this invention, high concentration doped polysilicon for leading out the base electrode is deposited with the thin first oxide film in between, so that the quantity of impurity diffused into the epitaxial layer which becomes the collector as a result of heat treatment later, is extremely small. Accordingly, the accompanying increase in the collector-base capacitance is extremely small. This effect is quite substantial when the present method is applied especially to a Bi-CMOS integrated circuit in which at least more than several times of heat treatment process are to be added. Moreover, in forming the opening formed by the reactive ion etching the thin first insulating film acts as a stopper so that etching of the epitaxial layer can be avoided. Since no damage is given to the surface by the reactive ion etching, there will not be generated a feeble leakage current in the base current. Furthermore, the planar dimensions of the graft base are determined in self-aligned manner so that the transistor will not be subjected to the influence of misalignment between the field oxide film and the emitter opening. As a result, the irregularity of the base resistance can be reduced to an extremely small value Therefore, according to this invention it is possible to realize a self-aligned bipolar transistor having a reduced collector-base capacitance as well as a base resistance, a high cut-off frequency and a high linearity.

Although the present invention has been described by reference to specific embodiments, the application of the invention is not limited to these embodiments alone, and it is obvious that various modifications are possible for persons skilled in the art without deviating from the spirit of the invention. For example, these embodiments have been described in terms of an NPN transistor, but the invention is also applicable to a PNP transistor by changing the conductivity types of the impurities. Similarly, the selective epitaxial base in the embodiments has been formed by a low pressure CVD method, but it can also be formed by means of molecular beam epitaxy (MBE).

## Claims

1. A method for manufacturing a bipolar transistor comprising steps of: preparing a semiconductor substrate of first conductivity type; forming sequentially a thin first insulating film, an electrically conductive film containing a second conductivity type impurity and a second insulating film on the semiconductor substrate; forming an opening by anisotropically etching of said second insulating film and said conductive film; exposing the semiconductor substrate by etching said first insulating film by using said opening as a mask; depositing a base layer of second conductivity type covering the exposed semiconductor substrate within said opening; forming a sidewall spacer on the side face of said opening by depositing a third insulating film and then etching the film back; and forming an emitter by forming a conductive film containing a second conductivity type impurity, then subjecting the device to heat treatment.

2. A method for manufacturing as claimed in claim 1, wherein said thin first insulating film is a silicon dioxide film and said second insulating film is a silicon nitride film.

3. A method for manufacturing as claimed in claim 1 or 2, wherein said conductive film containing a second conductivity type impurity is a boron-doped polysilicon film.

4. A method for manufacturing as claimed in any preceding claim, wherein said conductive film containing a second conductivity type impurity is a boron-doped polysilicon film with a metal silicide film of refractory metal arranged thereon.

5. A method for manufacturing as claimed in any preceding claim, wherein the ratio d/h of the distance d from the side face of said opening to the height h of an overhang formed beneath said conductive film containing a second conductivity type impurity formed in the step of exposing the semiconductors substrate by etching said first insulating film, is less than three.

6. A method for manufacturing as claimed in any preceding claim, further comprising a step of forming a buried layer by implanting a first conductivity type impurity into the semiconductor substrate through said opening

7. A bipolar transistor comprising a semiconductor substrate of a first conductivity type; a thin first insulating film, an electrically conductive film containing a second conductivity type impurity and a second insulating film on the semiconductor substrate; an opening in said second insulating film, said conductive film and said first insulating film; the opening being wider in the first insulating film than in the second insulating film and the conductive film; a base layer of second conductivity type covering the semiconductor substrate within said opening; an insulating sidewall spacer on the side face of said opening; and an emitter of a heat-treated conductive film containing a second conductivity type impurity.
